# EUROPEAN PATENT APPLICATION

(11) **EP 4 844 484 A1**
(43) Date of publication of application: **25.11.2026**
(21) Application number: 25177202.6
(22) Date of filing: 19.05.2025
(51) Int. Cl.: G03F 7/00, G02B 5/02

(54) **A MASKING BLADE, A RADIATION SYSTEM COMPRISING AT LEAST ONE MASKING BLADE, AN EXPOSURE APPARATUS COMPRISING A MASKING BLADE, AND AN ABERRATION MEASUREMENT METHOD USING A MASKING BLADE**

(71) Applicant: ASML Netherlands B.V., 5500 AH Veldhoven (NL)
(72) Inventor: GEELEN, Paul, Jean, Maurice, 5500 AH Veldhoven (NL); VOS, Hermanus, 5500 AH Veldhoven (NL); KHORSAND, Ali, Reza, 5500 AH Veldhoven (NL)
(74) Representative: ASML Netherlands B.V.

(57) **Abstract**

A masking blade for use in an optical beam path between an illuminator and a reticle or fiducial of an exposure apparatus, the masking blade comprising an aperture, a pair of optical elements arranged within the aperture at opposite surfaces of the aperture, the pair of optical elements being configured to receive a radiation beam from the illuminator by a first optical element, project the received radiation beam by the first optical element to the second optical element, project the received radiation beam by the second optical element to the reticle or fiducial, whereby at least one of the optical elements is configured to diffuse the received radiation beam.

## Description

### FIELD

The present invention relates to the field of lithography and semiconductor manufacturing. In particular, it pertains to a masking blade, a radiation system comprising at least one masking blade, an exposure apparatus comprising a masking blade, and an aberration measurement method using a masking blade.

### BACKGROUND

An exposure apparatus, such as a lithographic apparatus, is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Accurate alignment and image quality are essential in EUV lithography. To enable high-resolution patterning, it is important to characterize and compensate for optical aberrations in the projection optics and to ensure accurate positioning of the patterning device (e.g., a reticle) relative to the projection system. Aberration metrology systems are therefore integrated into lithographic apparatus to measure and correct for imperfections in the optical path.

One known approach to measuring optical aberrations includes the use of measurement marks in combination with grating structures. In certain metrology systems, such as those used for pupil sampling, a diffusive grating may be applied to a reference surface (fiducial) in combination with a transmissive grating on a measurement sensor. The diffusive grating scatters incident EUV radiation over a wide range of angles, thereby filling the numerical aperture (NA) of the projection optics with radiation. This allows for high spatial resolution measurements of the projection system's aberrations.

In some systems, the diffusive grating is implemented by forming a rough metallic layer, for example chromium (Cr), underneath an EUV reflective multilayer, such as a molybdenum-silicon/ruthenium (MoSi/Ru) stack. A uniform absorber layer is deposited on top of the reflective stack and subsequently patterned to form a transmissive grating structure.

While this approach is effective for internal fiducials, implementing similar diffuser technology on user patterning devices (reticles) presents challenges. In particular, integrating a diffusive grating structure into a user reticle would require significant changes to the reticle fabrication process. These changes may increase the risk of defects and impact production yield, making such integration undesirable for volume manufacturing environments.

As a result, enabling pupil-filling metrology, such as reticle alignment using diffusive structures, on user reticles remains a technical challenge. Current alignment systems for EUV lithography may rely on reticle marks without a diffuser, which can lead to measurement performance being sensitive to the shape of the illumination pupil used by the user. This pupil dependency introduces variability in measurement results and limits overall alignment accuracy.

There is therefore a need for improved diffuser technologies and metrology approaches that are compatible with user reticle processes and that reduce or eliminate sensitivity to the illumination pupil shape. Such improvements would support enhanced reticle alignment and optical aberration measurements in EUV lithography systems.

### SUMMARY

Therefore, according to an aspect of the invention there is provided a masking blade for use in an optical beam path between an illuminator and a reticle or fiducial of an exposure apparatus, the masking blade comprising:
an aperture,
a pair of optical elements arranged within the aperture at opposite surfaces of the aperture, the pair of optical elements being configured to
receive a radiation beam from the illuminator by a first optical element,
project the received radiation beam by the first optical element to the second optical element,
project the received radiation beam by the second optical element to the reticle or fiducial,
whereby at least one of the optical elements is configured to diffuse the received radiation beam.

In an embodiment, the pair of optical elements does not protrude the outer surfaces of the masking blade.

In an embodiment, the pair of optical elements are configured to define a portion of the radiation beam from the illuminator to the reticle or the fiducial, wherein the portion of the radiation beam received by the reticle or fiducial comprises a substantially filled illumination pupil representing a continuous set of angles of the radiation beam.

In an embodiment, a first one of the first optical element and the second optical element comprises a diffusor and a second one of the first optical element and second optical element comprises a reflective optical element.

In an embodiment, the first optical element is the diffusor configured to diffuse the received radiation beam.

In an embodiment, the second optical element is the reflective optical element configured to reflect the received radiation beam to the reticle or fiducial.

In an embodiment, the radiation beam is incident on the first optical element and/or the second optical element at an angle, wherein the angle is between 30-60 degrees, preferably between 40-50 degrees, more preferably at 42 degrees.

In an embodiment, the first optical element is parallel to the second optical element.

In an embodiment, a distance between the first optical element and the second optical element is between 2.0-3.0 mm, preferably between 2.2-2.8 mm, more preferably between 2.3 -2.5 mm.

In an embodiment, the first optical element and/or the second optical element are made of a multilayer structure comprising a stack of bilayers of molybdenum/Silicon (MoSi), also referred to as a MoSi multilayer stack.

According to an aspect of the invention, there is provided a radiation system comprising a laser system configured for irradiating droplets of a fuel with a laser beam to generate a radiation beam, wherein the radiation system comprises an optical path arranged to transport the radiation beam from an illuminator to a reticle or fiducial, wherein the optical path comprises at least one masking blade of the invention.

According to an aspect of the invention, there is provided an exposure apparatus comprising a masking blade of the invention.

In an embodiment, the radiation beam comprises EUV radiation.

According to an aspect of the invention, there is provided an aberration measurement method using a masking blade of the invention.

In an embodiment, the aberration measurement method comprises the step of moving the masking blade relative to the illuminator during an aberration measurement.

Further features of the disclosure, as well as the structure and operation of various embodiments of the disclosure, are described in detail below with reference to the accompanying drawings. It is noted that the disclosure is not limited to the specific embodiments described herein. Such embodiments are presented herein for illustrative purposes only. Additional embodiments will be apparent to persons skilled in the relevant art(s) based on the teachings contained herein.

### BRIEF DESCRIPTION OF THE DRAWINGS

The accompanying drawings, which are incorporated herein and form part of the specification, illustrate the present disclosure and, together with the description, further serve to explain the principles of the disclosure and to enable a person skilled in the relevant art(s) to make and use the disclosure. Embodiments of the present disclosure will now be described, by way of example only, with reference to the accompanying schematic drawings, in which:
Figure 1 depicts a lithographic system comprising a lithographic apparatus and a radiation source;
Figure 2A depicts a schematic illustration of a first cross section through an object on the support structure and a masking blade system of the lithographic apparatus of Figure. 1;
Figure 2B depicts a schematic illustration of a second cross section through an object on the support structure and a masking blade system of the lithographic apparatus of Figure 1;
Figure 3 depicts a plan view showing a Y masking blade and a X masking blade (dotted lines) of the lithographic apparatus of Figure 1;
Figure 4 depicts a schematic cross-sectional view through the Y masking blade shown in Figure 3.

The features of the present disclosure will become more apparent from the detailed description set forth below when taken in conjunction with the drawings, in which like reference characters identify corresponding elements throughout. In the drawings, like reference numbers generally indicate identical, functionally similar, and/or structurally similar elements. Additionally, generally, the leftmost digit(s) of a reference number identifies the drawing in which the reference number first appears. Unless otherwise indicated, the drawings provided throughout the disclosure should not be interpreted as to-scale drawings.

### DETAILED DESCRIPTION

The invention will be explained in more detail below with reference to drawings in which illustrative embodiments thereof are shown. The drawings are intended exclusively for illustrative purposes and not as a restriction of the inventive concept which is to cover all modifications, equivalents, and alternatives falling within the scope of the present invention. The scope of the invention is only limited by the definitions presented in the appended claims.

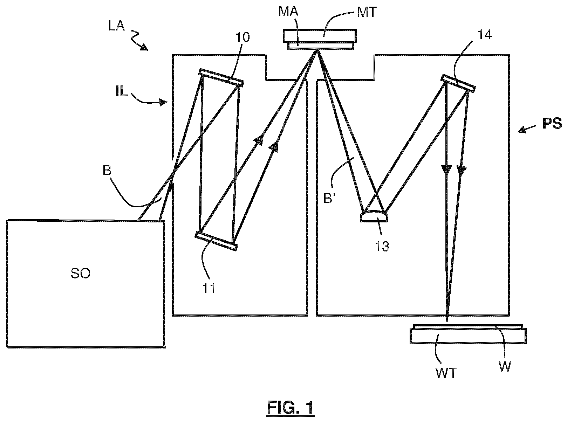

Fig. 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Fig. 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. The patterning device MA may be a mask or reticle, which imparts a pattern to a radiation beam transmitted or reflected by the patterning device. Well-known modes of operation include a stepping mode and a scanning mode. As is well known, the projection system PS may cooperate with support and positioning systems for the substrate W and the patterning device MA in a variety of ways to apply a desired pattern to many target portions across the substrate W. Programmable patterning devices may be used instead of reticles having a fixed pattern. The radiation for example may include electromagnetic radiation in the deep ultraviolet (DUV) or extreme ultraviolet (EUV) wavebands. The present disclosure is also applicable to other types of lithographic process, for example imprint lithography and direct writing lithography, for example by electron beam.

The depicted apparatus could be used in a variety of modes. In a scan mode, the patterning device support (e.g., mask table) MT and the substrate table WT are scanned synchronously while a pattern imparted to the radiation beam is projected onto a target portion (i.e., a single dynamic exposure). A direction in which the patterning device MA is scanned is called a scanning direction. The speed and direction of the substrate table WT relative to the patterning device support (e.g., mask table) MT may be determined by the (de-)magnification and image reversal characteristics of the projection system PS. In the scan mode, a maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In step mode, the patterning device support MT and the substrate table WT are kept essentially stationary, while an entire pattern imparted to the radiation beam B is projected onto a target portion at one time (i.e., a single static exposure). The substrate table WT is then shifted in a X and/or Y direction so that a different target portion may be exposed.

Combinations and/or variations on the above described modes of use or entirely different modes of use may also be employed. For example, in a step-and-scan mode an area that receives light at any point in time is smaller than the full field. This area is called a slit as described below. During the exposure process, both the substrate W and the patterning device MA are moved (at a substantially constant speed). The patterning device MA is scanned such that each portion of the pattern, corresponding to a size of the slit, gets sequentially illuminated. The reflected radiation from the patterning device MA is directed to the substrate W which is moved in synchronism to project the illuminated portion of the pattern at a correct location on the substrate W.

The largest area which can be exposed in a single exposure of a lithographic apparatus is defined by its scanning field area. The illumination system IL may comprise an illumination slit which determines the scanning field area, i.e. an illuminated area of the patterning device MA per a single scan. This is defined by a width of the illumination slit in the scanning direction (often designated as an X-direction) and the maximum scan length in the orthogonal direction (the non-scanning direction, often designated as a Y-direction) of the same plane (in short, the orthogonal direction Y). In some cases, the die area (the substrate area of the device being manufactured, referred to herein as the substrate field area or substrate region area) is larger than the maximum scanning field area. In this situation, some or all layers of the device need to be exposed on the substrate region (or substrate field) in multiple (e.g., two) separate adjacent exposures. For example: a substrate region twice as large as the maximum scanning field area may be exposed in two exposures: a first exposure using a first reticle comprising a first pattern is used to print a first substrate sub-region (e.g., first half in terms of area on the substrate) of the layer, and a second reticle comprising a second pattern is used to print a second sub-region of the layer (e.g., the second half) on the substrate, adjacent the first half therefore forming the complete layer. The two halves can be referred to as having been "stitched" together, with the process sometimes referred to as intra-die stitching.

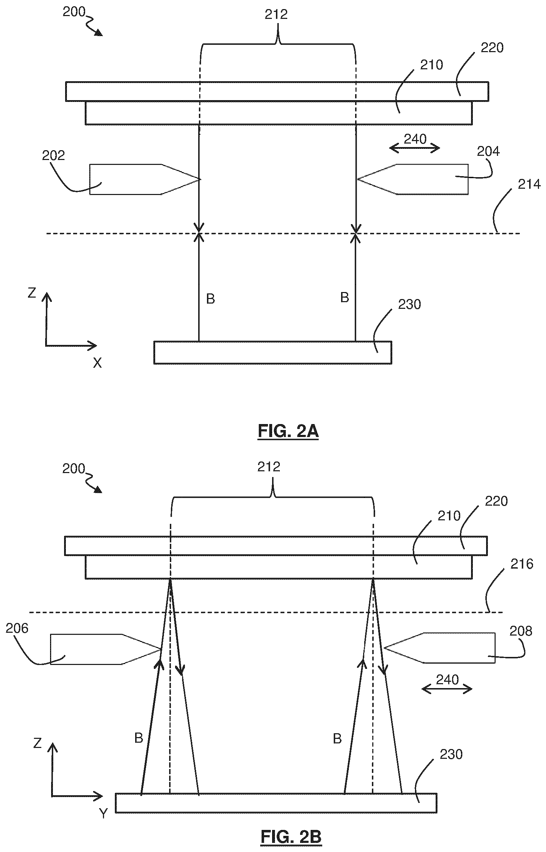

Figures 2A-2B depict a schematic illustration of cross-sections through an object on the support structure and masking blade system of the lithographic apparatus of Figure 1. The masking blade system 200 is configured to define the illumination region on a patterning device 210 (e.g., a reticle) supported on a support structure 220 (e.g., a reticle stage). An illuminator 230 is configured to project a radiation beam B onto a generally rectangular region 212 of the patterning device 210, hereinafter referred to as the slit.

The boundaries of the slit are defined by a set of four independently controllable masking blades: a pair of x-direction masking blades 202 and 204 (hereinafter referred to as X masking blade(s)), and a pair of y-direction masking blades 206 and 208 (hereinafter referred to as Y masking blade(s)). The X masking blades 202, 204 define the extent of the illumination region in a first direction (x-direction), and the Y masking blades 206, 208 define the extent of the illumination region in a second, orthogonal direction (y-direction).

Each masking blade 202, 204, 206, 208 is positioned proximate to, but offset from, the plane of the patterning device 210. The X masking blades 202 and 204 are arranged in a first plane 214, while the y-direction blades 206 and 208 are arranged in a second plane 216. Together, these blades define a rectangular field region 212 in the plane of the patterning device 210, onto which the radiation beam B is projected.

Each masking blade 202, 204, 206, 208 is operable to move between a retracted position, in which it does not obstruct the radiation beam B, and an inserted position, in which it at least partially intercepts the beam. This enables dynamic shaping of the illumination slit by selectively truncating the radiation beam in the x- and/or y-directions. By moving one or more of the masking blades 202, 204, 206, 208 (as indicated by the arrow 240) into the beam path, the illuminated region 212 can be confined to a desired portion of the patterning device 210.

In some embodiments, the x-direction may correspond to the non-scanning direction, and the y-direction may correspond to the scanning direction of the exposure apparatus. During exposure, the patterning device 210 or substrate may move in the y-direction so that a larger area can be exposed in a dynamic scanning operation.

During such dynamic exposure of a target portion of a substrate W, the target region is scanned through an exposure zone, which corresponds to a projection of the field region 212 of the patterning device 210 onto the substrate W via the projection system PS. To prevent unwanted exposure outside the target region, one of the y-direction masking blades 206 or 208 initially obstructs the beam at the start of scanning, functioning as a shutter. Similarly, at the end of the scanning exposure, the opposite y-direction masking blade blocks the beam to terminate exposure of the substrate W.

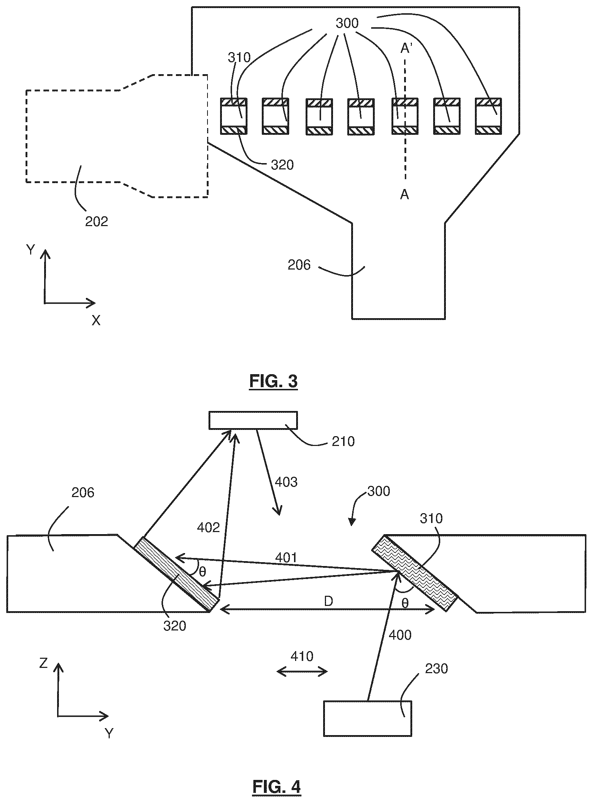

Figure 3 depicts a plan view of a portion of an exposure apparatus, showing a Y masking blade 206 and an X masking blade 202 (indicated in dashed lines). The Y masking blade 206 comprises multiple apertures 300, each arranged to locally modify a radiation beam received from an illuminator. Within each aperture 300, a pair of optical elements 310, 320 is positioned on opposing interior surfaces of the aperture 300.

Figure 4 shows a schematic cross-sectional view (section A-A') through the Y masking blade 206 shown in Figure 3. The cross-section shows the first optical element 310, positioned on one side of the aperture 300, and the second optical element 320, positioned on the other opposite side of the aperture 300. In the illustrated embodiment, the masking blade 206 is formed as a solid body and comprises slanted surfaces on both sides of the aperture 300. These slanted surfaces are configured to support the optical elements 310 and 320 and allow them to be arranged, e.g. glued or mounted, at a defined angle of incidence relative to the received radiation beams. The first optical element 310 is configured to receive and diffusely scatter the incoming radiation beam 400 from the illuminator 230. The second optical element 320 is configured to project the scattered radiation beam 401 received from the first optical element 310 toward the patterning device 210, e.g. a reticle, via reflection. Alternatively, instead of the patterning device 210 a fiducial may be used.

In the shown embodiment, the first optical element 310 comprises a diffusor having a diffusive optical surface, e.g., a microstructured or roughened reflective surface, that breaks up the angular coherence of the received radiation beam 400 and generates a broad angular spread of radiation 401. The second optical element 320 is a reflective optical element arranged to receive the scattered radiation beam 401 and reflect it toward the patterning device 210 via reflected radiation beam 402. Furthermore, an outgoing radiation beam 403 is generated from the patterning device 210 or fiducial. The outgoing radiation beam 403 is for example directed into the projection system and can be used to obtain information related to an aberration measurement. In this illustrated embodiment, the radiation beam 403 passes through the aperture 300 of the masking blade 206, such that the orientation of the radiation beam 403 matches that of a situation where the masking blade 206 is not present. The pair of optical elements 310, 320 may be configured such that their optical axes are substantially parallel. Preferably, the first optical element 310 comprises a reflective surface that is tuned to the wavelength of the incoming radiation beam 400. This may be achieved, for example, using a multilayer structure optimized for high reflectivity at the relevant wavelength, such as EUV light. The multilayer structure for example comprises stack of alternating layers of molybdenum and silicon. Similarly, the second optical element 320 is also configured to reflect the received radiation beam 401 and may comprise a comparable reflective surface. The use of wavelength-specific reflective surfaces on both optical elements 310, 320 ensures efficient redirection of the radiation beam through the optical path defined by the masking blade 206.

In an alternative configuration, the positions of the optical elements 310, 320 may be reversed, such that the first optical element 310 is reflective and the second optical element 320 is diffusive, i.e. reflecting the incident radiation in a diffusive manner. In this case, the radiation beam 400 from the illuminator 230 is first reflected by the first optical element 310 and then scattered toward the patterning device 210 or fiducial by the second optical element 320. While this setup still produces a diffusive illumination profile at the patterning device or fiducial, it is generally less optimal. In particular, the effectiveness of the scattering can become more sensitive to variations in the incoming radiation beam shape or angular distribution. As a result, performance consistency may be reduced, especially if the angular content of the radiation beam changes over time or differs between exposures. Nonetheless, this alternative design can still be advantageous in certain integration scenarios or when space constraints favor a different optical arrangement.

The pair of optical elements 310, 320 are arranged entirely within the aperture 300 such that neither protrudes beyond the outer surfaces of the Y masking blade 206. This configuration enables mechanical protection of the optics and integration within a compact optical beam path, reducing the risk of damage.

In an embodiment, a distance D between the first optical element 310 and the second optical element 320 is between 2.0-3.0 mm, preferably between 2.2-2.8 mm, more preferably between 2.3 -2.5 mm. The required dimensions of the first optical element 310 and the second optical element 320 arranged within the aperture 300 of the Y masking blade 206 depend on specific system parameters of the exposure apparatus, particularly those of the illuminator 230 and the projection optics. Two parameters play a role in determining the necessary optical surface area: the NA of the projection system and the distance between the Y masking blade 206 and the patterning device 210. A higher NA implies that the radiation beam approaches the patterning device 210 at steeper angles, and a larger separation distance increases the lateral beam spread. As a result, the pair of optical elements 310, 320 must be sufficiently wide to intercept and redirect the full radiation beam profile. For example, the required width of each optical element is at least 1.8 mm, while the height of each optical element (in the radiation beam propagation direction) remains below 2 mm. For more advanced systems, which typically operate at a higher NA and/or with larger masking blade-to-patterning device distances, the required width of each optical element increases to over 3.5 mm, while the height of each optical element can still remain below 2 mm. These dimensional specifications ensure that the full illumination pupil is intercepted and processed by the optical elements, enabling effective pupil filling and accurate radiation beam redirection to the patterning device.

As mentioned before, the Y masking blade 206 is designed to define a specific portion of the radiation beam 400, shaping and projecting it toward the patterning device 210, e.g. a reticle, or fiducial. The diffusion and reflection of the radiation beam 400 provide an evenly and fully filled lens pupil at the reticle or fiducial location, thereby ensuring that the portion of the radiation beam received by the reticle or fiducial comprises a substantially filled illumination pupil representing a continuous set of angles of the radiation beam. This full and even pupil filling at the object plane enables high-resolution optical measurements and exposures that are independent of the illumination pupil shape used by a user or specified for the exposure tool. This reduces systematic variations in performance and improves the robustness and accuracy of alignment and overlay processes, particularly for metrology applications.

In an embodiment, the radiation beam 400 and the scattered radiation beam 401 are incident on the first optical element 204 and the second optical element 206, respectively, at an angle of incidence θ, which may be between 30° and 60°, preferably between 40° and 50°, and more preferably around 42°, which optimizes both scattering efficiency and reflection.

The arrangement of the pair of optical elements 310, 320 within the Y masking blade 200 may also be used to support aberration measurement and alignment functionality on reticles, without requiring substantial modification to the reticle manufacturing process for the user. In this application, the radiation beam first impinges on the diffusive optical element 310, which serves to scatter the radiation beam and generate a wide angular distribution of radiation. This scattered and diffused beam is then reflected by the second optical element 320, which is oriented to direct the radiation toward the metrology marks (e.g., grating structures) on the reticle. As a result of this optical path, comprising diffusion followed by reflection, the reticle-mounted mark is illuminated with radiation having a substantially filled illumination pupil, even if the original pupil shape of the radiation beam from the illuminator was limited or asymmetric. In other words, the metrology mark is illuminated by a radiation beam encompassing the full angular range supported by the NA of the projection optics. This approach allows the mark to receive radiation from all relevant incident angles, enabling high spatial resolution measurement of optical aberrations by capturing how different angles of illumination interact with the structure of the mark. This makes it possible to detect subtle phase errors or wavefront distortions across the projection system with high precision.

A significant benefit of this architecture is that existing reticle marks can be reused, or, if needed, only minor design updates to the user reticle pattern are required, such as defining an appropriate grating structure in the reticle design database. This means the optical performance improvements, including reduced sensitivity to the pupil shape and increased measurement robustness, can be realized without fundamental changes to the reticle fabrication flow. For instance, a modification in the reticle layout file or manual may suffice, avoiding cost and yield impacts. Moreover, since the diffusor equalizes the angular content of the radiation beam before it reaches the mark, user-specific variations in illumination settings no longer influence the metrology performance, making the system significantly more tolerant to tool-to-tool and lot-to-lot variation.

In a further embodiment, the Y masking blade 206 described above is employed in an aberration measurement method for measuring optical aberrations in an exposure apparatus. In this method, the Y masking blade 206 is configured to move relative to the illuminator 230 during the aberration measurement, as indicated by double-sided arrow 410. Such relative movement between the masking blade 206 and the illuminator 230, e.g., via translational or rotational actuation of the Y masking blade 206 within the plane of the illumination field, results in a dynamic change in the angular distribution of the radiation beam 402 projected toward the reticle or fiducial. More specifically, as the diffusive first optical element 310 is moved through the radiation beam 400, it projects the scattered radiation beam 401 at varying angles toward the second reflective optical element 320, thereby increasing the effective pupil filling during the course of the aberration measurement. This increased pupil filling enhances the uniformity and completeness of the angular coverage at the location of the metrology mark on the reticle or fiducial. As a result, the measurement benefits from more reliable and representative sampling of the system's optical aberrations across the full NA of the projection optics. This improves the sensitivity and accuracy of the aberration characterization, which is especially important for high-resolution lithography.

Moreover, because the angular diversity of the scattered radiation beam is achieved through motion of the Y masking blade 206 itself, the pair of optical components 310, 320 integrated into the Y masking blade 206 can be made with smaller physical dimensions. Since the pupil filling is accomplished over time through movement rather than via larger static optics, the overall footprint of the pair of optical elements 310, 320 can be reduced, which allows the masking blade system 200 to maintain compatibility with existing blade housings and mechanical interfaces. This design flexibility can facilitate retrofitting or integration into current lithographic systems without significant hardware redesign.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A masking blade for use in an optical beam path between an illuminator and a reticle or fiducial of an exposure apparatus, the masking blade comprising:
an aperture,
a pair of optical elements arranged within the aperture at opposite surfaces of the aperture, the pair of optical elements being configured to
receive a radiation beam from the illuminator by a first optical element, project the received radiation beam by the first optical element to a second optical element,
project the received radiation beam by the second optical element to the reticle or fiducial,
whereby at least one of the optical elements is configured to diffuse the received radiation beam.

2. The masking blade of claim 1, wherein the pair of optical elements does not protrude the outer surfaces of the masking blade.

3. The masking blade of any of the preceding claims, wherein the pair of optical elements are configured to define a portion of the radiation beam from the illuminator to the reticle or the fiducial, wherein the portion of the radiation beam received by the reticle or fiducial comprises a substantially filled illumination pupil representing a continuous set of angles of the radiation beam.

4. The masking blade of any of the preceding claims, wherein a first one of the first optical element and the second optical element comprises a diffusor and a second one of the first optical element and second optical element comprises a reflective optical element.

5. The masking blade of claim 4, wherein the first optical element is the diffusor configured to diffuse the received radiation beam.

6. The masking blade of claim 4 or claim 5, wherein the second optical element is the reflective optical element configured to reflect the received radiation beam to the reticle or fiducial.

7. The masking blade of any of the preceding claims, wherein the radiation beam is incident on the first optical element and/or the second optical element at an angle, wherein the angle is between 30-60 degrees, preferably between 40-50 degrees, more preferably at 42 degrees.

8. The masking blade of any of the preceding claims, wherein the first optical element is parallel to the second optical element.

9. The masking blade of any of the preceding claims, wherein a distance between the first optical element and the second optical element is between 2.0-3.0 mm, preferably between 2.2-2.8 mm, more preferably between 2.3 -2.5 mm.

10. The masking blade of any of the preceding claims, wherein the first optical element and/or the second optical element are made of a multilayer structure comprising alternating layers of molybdenum and silicon.

11. A radiation system comprising a laser system configured for irradiating droplets of a fuel with a laser beam for generating a radiation beam, wherein the radiation system comprises an optical path arranged to transport the radiation beam from an illuminator to a reticle or fiducial, wherein the optical path comprises at least one masking blade of any of the preceding claims.

12. An exposure apparatus comprising a masking blade of any of the claims 1-11.

13. The exposure apparatus of claim 12, wherein the radiation beam comprises EUV radiation.

14. An aberration measurement method using a masking blade of any of the claims 1-11.

15. The aberration measurement method of claim **14,** comprising the step of moving the masking blade relative to the illuminator during an aberration measurement.
